# FASCICULE DE BREVET EUROPEEN

(11) **EP 2 828 194 B1**
(45) Date de publication et mention de la délivrance du brevet: **26.12.2018**
(21) Numéro de dépôt: 13719897.4
(22) Date de dépôt: 19.03.2013
(51) Int. Cl.: B82Y 30/00, H05B 33/14, H01L 33/06, H01L 33/50

(54) **DISPOSITIF ÉMETTANT DE LA LUMIÈRE CONTENANT DES NANOCRISTAUX COLLOÏDAUX SEMI-CONDUCTEURS ANISOTROPES APLATIS**
LICHTEMITTIERENDE VORRICHTUNG MIT ABGEFLACHTEN ANISOTROPEN KOLLOIDALEN HALBLEITERNANOKRISTALLEN
LIGHT-EMITTING DEVICE CONTAINING FLATTENED ANISOTROPIC COLLOIDAL SEMICONDUCTOR NANOCRYSTALS

(30) Priorité: 19.03.2012 FR 1200815; 19.10.2012 FR 1259990
(43) Date de publication de la demande: 28.01.2015
(73) Titulaire: Nexdot, 93230 Romainville (FR)
(72) Inventeur: MAHLER, Benoît, F-75005 Paris (FR); PONS, Thomas, F-92160 Antony (FR); CASSETTE, Elsa, F-75005 Paris (FR)
(74) Mandataire: Icosa
(86) Numéro de dépôt international: PCT/FR2013/050579
(87) Numéro de publication internationale: WO 2013/140083

(56) Documents cités:
- WO-A2-2010/124212
- US-A- 5 422 489
- US-A1- 2010 148 156
- US-B1- 7 332 211

## Description

### DOMAINE DE L'INVENTION

La présente invention concerne les dispositifs qui émettent de la lumière en réponse à une excitation électrique ou lumineuse, tels que les diodes électroluminescentes, les afficheurs, les liseuses, etc. On trouve de tels dispositifs par exemple dans les afficheurs, les téléviseurs, les téléphones portables, les tablettes, ou encore les ordinateurs. Les dispositifs du genre en question présentent encore, malgré des progrès réguliers, un certain nombre de limitations tant en ce qui concerne le rendu des couleurs que le contraste, la brillance, le rendement énergétique et l'impression visuelle en fonction de l'angle d'observation.

### ÉTAT DE LA TECHNIQUE

Afin de reconstituer les couleurs dans toute leur variété, on procède en général par synthèse additive d'au moins trois couleurs complémentaires, en particulier le rouge, le vert et le bleu. Dans un diagramme de chromaticité, le sous-ensemble des couleurs accessibles en mélangeant en différentes proportions ces trois couleurs est constitué par le triangle formé par les trois coordonnées associées aux trois couleurs rouge, vert et bleu. Ce sous-ensemble constitue ce que l'on appelle un gamut.

La majorité des dispositifs d'affichage en couleurs fonctionne sur ce principe de trichromie : chaque pixel est constitué de trois sous-pixels, un rouge, un vert et un bleu, dont le mélange selon des intensités différentes permet de restituer une impression colorée.

Un écran d'affichage rétroéclairé ou luminescent tel qu'un écran à cristaux liquides d'ordinateur doit présenter le gamut le plus grand possible pour une reproduction fidèle des couleurs. Pour cela, les sous-pixels le composant doivent être de couleurs les plus saturées possibles afin de décrire le plus grand gamut possible. Une source lumineuse présente une couleur saturée si celle-ci est proche d'une couleur monochromatique. D'un point de vue spectral, cela signifie que la lumière émise par la source est composée d'une seule bande étroite de longueurs d'onde. On rappelle qu'une teinte très saturée a une couleur vive et intense alors qu'une teinte moins saturée paraît plus fade et grise.

Il est donc important de disposer de sources lumineuses dont les spectres d'émission sont étroits et donc de couleurs saturées.

Par exemple, dans le cas d'un écran d'affichage couleur, les sous-pixels rouges, verts et bleus le composant doivent posséder un spectre maximisant le gamut du système d'affichage, ce qui revient à présenter l'émission la plus étroite possible du point de vue spectral.

Il est possible de distinguer deux types d'afficheurs polychromes émettant de la lumière :
- les écrans d'affichage rétro-éclairés, dans lesquels une lumière blanche provenant du rétro-éclairage est filtrée par des filtres colorés et dont l'intensité est contrôlée par un système à cristaux liquides : ce sont les écrans à cristaux liquides¹ (LCD en anglais pour « Liquid Crystal Display »),
- les écrans d'affichage directement émissifs, dans lesquels chaque pixel est composé d'au moins trois sous-pixels correspondant à trois couleurs de base. Chaque sous-pixel est un émetteur de lumière indépendamment adressé, souvent à travers un système matriciel ou multiplexé, dont l'intensité lumineuse émise est alors directement réglée. C'est le cas des écrans plasma et des écrans à diodes électroluminescentes tels que les écrans OLEDs² (pour « Organic Light Emiting Diode »). Ces dispositifs utilisent un matériau émettant de la lumière en réponse à une excitation.

Dans les écrans à cristaux liquides, la couleur des pixels est définie par le filtrage d'une source primaire blanche par des filtres rouges, verts et bleus. Les spectres des trois sous pixels correspondent donc à la multiplication du spectre d'émission de la source primaire, qui est en général une matrice de diodes blanches ou un tube fluorescent à cathode froide, par le spectre de transmission des filtres utilisés. Le fait d'optimiser les spectres de la source lumineuse primaire ou des filtres colorés permet donc d'améliorer le gamut. Toutefois, une grande partie de la lumière émise par la source primaire blanche est soit réabsorbée par les polariseurs³ et les filtres colorés qui composent l'écran, soit déviée par diffusion et effet guide d'onde dans les différentes couches. Elle n'atteint donc pas l'observateur, ce qui limite fortement le rendement énergétique des écrans à cristaux liquides. Cela impose alors, pour limiter la consommation électrique, à rechercher un compromis gamut - luminosité.

Afin d'augmenter le gamut et la brillance de l'écran sans modification importante des filtres et de la source lumineuse primaire il a été récemment proposé d'ajouter un film fluorescent contenant des points quantiques colloïdaux, dits « quantum dots », entre la source lumineuse et les pixels afin de modifier le spectre de la lumière issue de la source après traversée du film en question et ainsi de renforcer la saturation des trois sous-pixels^{4, 5}. Toutefois cette solution, bien qu'améliorant le gamut, diminue la brillance de l'écran.

Il a également été proposé de remplacer les filtres par des convertisseurs de longueur d'onde verts, rouges et bleus absorbant la lumière primaire, bleue ou ultraviolette par exemple, et réémettant la couleur spécifique à chaque convertisseur^{6,7}. Pour cela on utilise un matériau contenant des fluorophores, qui absorbent la lumière issue d'une source d'excitation primaire et la réémettent à une longueur d'onde plus élevée. Cette solution présente toutefois des problèmes de stabilité, de rendement de fluorescence et de finesse spectrale des fluorophores utilisés dans les convertisseurs de longueur d'onde en question.

Les afficheurs directement émissifs, tels que les afficheurs composés de diodes électroluminescentes, présentent potentiellement une consommation énergétique plus faible ; il n'y a pas ou peu de pertes par filtrage. Toutefois, lorsqu'on utilise des couches semi-conductrices, comme dans les diodes inorganiques ou des couches polymères comme dans le cas des OLEDs, des pertes de lumière par réflexions totales internes dans les couches en question, réduisent la lumière totale qui parvient à l'observateur.

Dans les afficheurs directement émissifs, la nature de l'excitation peut-être diverse :
- électrique par injection de charges comme dans le cas des diodes électroluminescentes organiques ou inorganiques.
- optique, par absorption de photons de longueur d'onde plus courte que la longueur d'onde d'émission, comme dans le cas des convertisseurs de longueurs d'onde ou des écrans à plasma.

De nombreux matériaux émissifs ont étés proposés pour tenter de couvrir l'ensemble du spectre visible.

Ainsi, les fluorophores organiques, présents par exemple dans les OLEDs ont un rendement quantique dans le visible élevé, couramment supérieur à 90%. Ils sont généralement peu stables, se dégradant par exemple sous l'effet de l'oxydation ou de rayonnements, ce qui diminue la durée de vie des dispositifs les contenant. De plus la largeur des spectres de fluorescence peut être assez grande, ce qui ne permet pas d'obtenir un gamut important. Enfin, la longueur d'onde d'excitation optimale peut être différente pour chaque fluorophore, rendant difficile leur intégration dans un système présentant une source d'excitation commune.

Les oxydes ou complexes de terres rares sont des matériaux émissifs couramment utilisés, par exemple dans les écrans à plasma et les OLEDs. Dans ce cas, le matériau émissif est beaucoup plus stable car peu sensible à l'oxydation. La largeur des pics d'émission peut être très faible, de l'ordre de dix nanomètres mais la section efficace d'absorption de ces matériaux est faible, pouvant nécessiter l'emploi de quantités importantes. De plus, leur longueur d'onde d'émission n'est pas modifiable, car définie par le matériau, par exemple le complexe de terres rares utilisé. Cela constitue une limitation importante, ne permettant pas à ce type d'émetteur de couvrir tout le spectre visible.

Les matériaux émissifs des écrans plasma ou des OLEDs comprennent parfois un oxyde de métal de transition. De même que pour les oxydes de terres rares, le matériau fluorescent est très stable car peu sensible à l'oxydation. Par contre, la largeur spectrale de la fluorescence est très élevée, typiquement de cinquante à plusieurs centaines de nanomètres, ce qui ne permet pas de générer de couleurs saturées, et donc de présenter un gamut important.

Les nanoparticules de semi-conducteurs, communément appelés « quantums dots » en anglais, constituent une alternative en tant que matériau émissif. Celles-ci présentent un spectre de fluorescence étroit, 30nm environ de largeur à mi-hauteur, et offrent la possibilité d'émettre dans l'ensemble du spectre visible ainsi que dans l'infra-rouge avec une seule source d'excitation dans l'ultraviolet^{8,9}. Toutefois, elles ne permettent pas d'optimiser la lumière reçue par l'observateur et donc le rendement énergétique du dispositif. Dans ce cas une amélioration du gamut des afficheurs polychromes nécessite une finesse des spectres d'émission non accessible aux quantum dots.

L'objet de la présente invention est donc de fournir un nouveau dispositif d'émission de lumière permettant une grande finesse spectrale d'émission, un contrôle parfait de la longueur d'onde d'émission, de la directivité et/ou de la polarisation de la lumière émise. La présente invention permet donc d'améliorer sensiblement la brillance et le gamut des afficheurs composés de tels dispositifs.

US 7,332,211 B1 et US 2010/0148156 A1 divulguent des composants émetteurs de lumière comprenant une pluralité de nanocristaux colloïdaux semi-conducteurs anisotropes aplatis.

### RÉSUMÉ

La présente invention a pour objet un composant selon la revendication 1.

Dans un mode de réalisation, le au moins un nanocristal colloïdal semi-conducteur anisotrope aplati est un nanofeuillet colloïdal semi-conducteur.

Dans un mode de réalisation, le au moins un nanocristal colloïdal semi-conducteur anisotrope aplati contient l'un au moins des composés du groupe IV, du groupe III-V, du groupe II-VI, du groupe III-VI, du groupe I-III-VI, du groupe II-V ou du groupe IV-VI.

Dans un mode de réalisation, le au moins un nanocristal colloïdal semi-conducteur anisotrope aplati contient l'un au moins des composés suivants : Si, Ge, CdS, CdSe, CdTe, ZnS, ZnSe, ZnTe, HgS, HgSe, HgTe, PbS, PbSe, PbTe, CuInS₂, CuInSe₂, AgInS₂, AgInSe₂, CuS, Cu₂S, Ag₂S, Ag₂Se, Ag₂Te, InN, InP, InAs, InSb, In₂S₃, Cd₃P₂, Zn₃P₂, Cd₃As₂, Zn₃As₂, ZnO, AlN, AlP, AlAs, AlSb, GaN, GaP, GaAs, GaSb FeS₂, TiO₂, Bi₂S₃, Bi₂Se₃, Bi₂Te₃.

Dans un mode de réalisation, chaque nanocristal colloïdal semi-conducteur anisotrope aplati est une hétéro-structure comprenant un nanocristal colloïdal semi-conducteur anisotrope aplati.

Dans un mode de réalisation, chaque un nanocristal colloïdal semi-conducteur anisotrope aplati est recouvert totalement d'un semi-conducteur de composition chimique différente.

Dans un mode de réalisation, chaque nanocristal colloïdal semi-conducteur anisotrope aplati présente un spectre de fluorescence étroit, de largeur à mi-hauteur inférieure à 30nm, ou à 25nm, ou à 23nm, ou préférentiellement à 20nm.

Dans un mode de réalisation, le support est transparent pour la lumière émise dans au moins une direction vers un observateur situé à l'extérieur du composant, la face du support par laquelle la lumière est émise vers l'observateur étant définie face émettrice.

Dans un mode de réalisation, le support contient un liquide ayant les propriétés des cristaux liquides.

Dans un mode de réalisation, le support est souple ou rigide.

Dans un mode de réalisation, le support comprend un matériau inorganique ou un matériau organique.

Dans un mode de réalisation, le support contient un matériau polymère.

Dans un mode de réalisation, le composant comprend au moins deux nanocristaux colloïdaux semi-conducteurs anisotropes aplatis ayant des caractéristiques, dimensions et/ou compositions chimiques et/ou longueurs d'onde d'émission, différentes.

Selon l'invention, sensiblement tous les nanocristaux aplatis du composant ont les normales à leurs surfaces sensiblement parallèles à une direction donnée.

La présente invention a également pour objet un système d'émission de lumière comportant un composant et au moins un moyen d'excitation comprenant des moyens d'application aux nanocristaux colloïdaux semiconducteurs anisotropes aplatis d'un champ électromagnétique, notamment une source lumineuse, dont une partie au moins de la lumière émise est absorbée par les nanocristaux colloïdaux semiconducteurs anisotropes aplatis, telle une diode à base de nitrure de gallium.

La présente invention a également pour objet un appareil comprenant au moins un composant et/ou un système selon l'une quelconque des revendications précédentes.

### EXPOSÉ DE L'INVENTION

La présente invention a pour objet un composant selon la revendication 1.

La présente invention a également pour objet un dispositif d'excitation comportant les moyens d'excitation pour le dispositif émettant de la lumière précité. les moyens d'excitation comprenant des moyens d'injection de charges électriques, électrons et/ou trous, au sein du nanocristal colloïdal semi-conducteur anisotrope aplati ou des moyens d'application au nanocristal colloïdal semi-conducteur anisotrope aplati d'un champ électromagnétique.

Un nanocristal colloïdal semi-conducteur anisotrope aplati, selon l'invention, est une particule cristalline dont au moins une des dimensions, de préférence l'épaisseur, est plus petite que les deux autres d'un facteur 1,5 au moins.

Dans un mode de réalisation de l'invention, la particule cristalline telle que décrite ci-dessus est un nanofeuillet, ou une hétéro-structure contenant un quantum dot ou un nanofeuillet.

Dans un mode de réalisation de l'invention, une hétéro-structure est une structure de type coeur/coque dans laquelle la coque recouvre totalement ou partiellement le coeur.

Dans un mode de réalisation l'hétéro-structure, telle que décrite ci-dessus, comprend un coeur composé d'un matériau et une coque composée d'un matériau différent du matériau composant le coeur.

Dans un mode de réalisation de l'invention, la coque peut être composée de plusieurs matériaux différents ou identiques entre eux.

Dans un mode de réalisation, l'hétéro-structure telle que décrite ci-dessus est composée d'un coeur comprenant un quantum dot ou un nanofeuillet et d'une coque, ladite hétéro-structure ayant au moins une des dimensions, de préférence l'épaisseur, est plus petite que les deux autres d'un facteur 1,5 au moins.

Dans un mode de réalisation, les moyens d'excitation comprennent des moyens d'injection de charges électriques, électrons et/ou trous, au sein du nanocristal colloïdal semi-conducteur anisotrope aplati.

Dans un mode de réalisation, les moyens d'excitation comprennent des moyens d'application au nanocristal colloïdal semi-conducteur anisotrope aplati d'un champ électromagnétique.

Dans un mode de réalisation, la source de champ électromagnétique est une source lumineuse dont une partie au moins de la lumière émise est absorbée par le nanocristal colloïdal semi-conducteur anisotrope aplati.

Dans un mode de réalisation, la source lumineuse dont une partie au moins de la lumière émise est absorbée par le nanocristal colloïdal semi-conducteur anisotrope aplati est une diode à base de nitrure de gallium (GaN).

Dans un mode de réalisation, les moyens d'excitation comprennent au moins un dipôle électrique ou magnétique couplé par interactions électromagnétiques au nanocristal colloïdal semi-conducteur anisotrope aplati.

Dans un mode de réalisation, le nanofeuillet, ou le nanofeuillet ou nanocristal initial présent dans l'hétéro-structure, présente au moins une de ses dimensions, de préférence l'épaisseur, étant de 0,3 nm à moins de 1 µm, de 0,3 nm à moins de 500 nm, de 0,3 nm à moins de 250 nm, de 0,3 nm à moins de 100 nm, de 0,3 nm à moins de 50 nm, de 0,3 nm à moins de 25 nm, de 0,3 nm à moins de 20 nm, de 0,3 nm à moins de 15 nm, de 0,3 nm à moins de 10 nm, de 0,3 nm à moins de 5 nm.

Dans un mode de réalisation, le nanofeuillet, ou le nanofeuillet ou nanocristal initial présent dans l'hétéro-structure, présente au moins une dimension latérale de 0,3 nm à au moins 1 mm, de 0,3 nm à 100 µm, de 0,3 nm à 10 µm, de 0,3 nm à 1 µm, de 0,3 nm à 500 nm, de 0,3 nm à 250 nm, de 0,3 nm à 100 nm, de 0,3 nm à 50 nm, de 0,3 nm à 25 nm.

Dans un mode de réalisation, au moins une des dimensions latérales (longueur ou largeur), préférentiellement les deux dimensions latérales, du nanocristal colloïdal semi-conducteur anisotrope aplati représente(nt) au moins 1,5 fois son épaisseur, au moins 2 fois son épaisseur, au moins 2,5 fois son épaisseur, au moins 3 fois son épaisseur, au moins 3,5 fois son épaisseur, au moins 4 fois son épaisseur, au moins 4,5 fois son épaisseur, au moins 5 fois son épaisseur.

Dans un mode de réalisation, l'épaisseur du nanocristal colloïdal semi-conducteur anisotrope aplati est de 0,5 nm à moins de 1 µm, de 0,5 nm à moins de 500 nm, de 0,5 nm à moins de 250 nm, de 0,5 nm à moins de 100 nm, de 0,5 nm à moins de 50 nm, de 0,5 nm à moins de 25 nm, de 0,5 nm à moins de 20 nm, de 0,5 nm à moins de 15 nm, de 0,5 nm à moins de 10 nm, de 0,5 nm à moins de 5 nm.

Dans un mode de réalisation, les dimensions latérales du nanocristal colloïdal semi-conducteur anisotrope aplati sont de au moins 0,75 nm à au moins 1,5 mm.

Dans un mode de réalisation, au moins une des dimensions latérales du nanocristal colloïdal semi-conducteur anisotrope aplati est de 2 nm à 1,5 mm, de 2 nm à 1 mm, de 2 nm à 100 µm, de 2 nm à 10 µm, de 2 nm à 1 µm, de 2 nm à 100 nm, de 2 nm à 10 nm.

Dans un mode de réalisation, le nanofeuillet, ou le nanofeuillet ou nanocristal initial présent dans l'hétéro-structure, est composé de semi-conducteurs du groupe IV, III-V, II-VI, I-III-VI, II-V, III-VI.

Dans un mode de réalisation, le nanofeuillet, ou le nanofeuillet ou nanocristal initial présent dans l'hétéro-structure, comprend un matériau MₓE_{y} où :
M est Zn, Cd, Hg, Cu, Ag, Al, Ga, In, Si, Ge, Pb, Sb ou un mélange de ceux-ci,
E est O, S, Se, Te, N, P, As ou un mélange de ceux-ci, et
x et y sont indépendamment un nombre décimal de 0 à 5, et non simultanément nuls.

Dans un mode de réalisation, le nanofeuillet, ou le nanofeuillet ou nanocristal initial présent dans l'hétéro-structure, contient l'un au moins des composés suivants : Si, Ge, CdS, CdSe, CdTe, ZnS, ZnSe, ZnTe, HgS, HgSe, HgTe, PbS, PbSe, PbTe, CuInS₂, CuInSe₂, AgInS₂, AgInSe₂, CuS, Cu₂S, Ag₂S, Ag₂Se, Ag₂Te, InN, InP, InAs, InSb, In₂S₃, Cd₃P₂, Zn₃P₂, Cd₃As₂, Zn₃As₂, ZnO, AlN, AlP, AlAs, AlSb, GaN, GaP, GaAs, GaSb, ou un mélange de ceux-ci.

Dans un mode de réalisation, le nanocristal colloïdal semi-conducteur anisotrope aplati est composé de semi-conducteurs du groupe IV, III-V, II-VI, I-III-VI, II-V, III-VI.

Dans un mode de réalisation, le nanocristal colloïdal semi-conducteur anisotrope aplati comprend un matériau MₓE_{y} où :
M est Zn, Cd, Hg, Cu, Ag, Al, Ga, In, Si, Ge, Pb, Sb ou un mélange de ceux-ci,
E est O, S, Se, Te, N, P, As ou un mélange de ceux-ci, et
x et y sont indépendamment un nombre décimal de 0 à 5, et non simultanément nuls.

Dans un mode de réalisation, le nanocristal colloïdal semi-conducteur anisotrope aplati contient l'un au moins des composés suivants : Si, Ge, CdS, CdSe, CdTe, ZnS, ZnSe, ZnTe, HgS, HgSe, HgTe, PbS, PbSe, PbTe, CuInS₂, CuInSe₂, AgInS₂, AgInSe₂, CuS, Cu₂S, Ag₂S, Ag₂Se, Ag₂Te, InN, InP, InAs, InSb, In₂S₃, Cd₃P₂, Zn₃P₂, Cd₃As₂, Zn₃As₂, ZnO, AlN, AlP, AlAs, AlSb, GaN, GaP, GaAs, GaSb, ou un mélange de ceux-ci.

Dans un mode de réalisation, le nanocristal colloïdal semi-conducteur anisotrope aplati contient un alliage des matériaux énoncés ci-dessus.

Dans un mode de réalisation le nanocristal colloïdal semi-conducteur anisotrope aplati est composé d'un nanocristal ou d'un nanofeuillet initial recouvert partiellement ou totalement sur au moins une face par au moins une monocouche ou couche de matériau supplémentaire.

Dans un mode de réalisation où plusieurs monocouches ou couches recouvrent tout ou partie du nanocristal ou du nanofeuillet initial, ces monocouches ou couches peuvent être composées du même matériau ou composées de différents matériaux.

Au sens de la présente invention, le terme « couche » correspond à un film ou une couche continu ou partiel ayant au moins 1 atome d'épaisseur. Le terme « monocouche » correspond à un film ou une couche continu ou partiel ayant 1 atome d'épaisseur. Les atomes composant la couche ou la monocouche peuvent être identiques ou différents.

Dans un mode de réalisation, le nanocristal colloïdal semi-conducteur anisotrope aplati est homo-structuré, i.e. que le nanocristal ou le nanofeuillet initial et la au moins une monocouche ou couche sont composés du même matériau.

Dans un mode de réalisation, le nanocristal colloïdal semi-conducteur anisotrope aplati est hétéro-structuré, i.e. que le nanocristal ou le nanofeuillet initial et la au moins une monocouche ou couche sont composés d'au moins deux matériaux différents.

Dans un mode de réalisation, le nanocristal colloïdal semi-conducteur anisotrope aplati peut comprendre le nanocristal ou le nanofeuillet initial et 1, 2, 3, 4, 5 ou plus monocouches ou couches recouvrant tout ou partie du nanocristal ou du nanofeuillet initial, lesdites monocouches ou couches étant de composition identique au nanocristal ou au nanofeuillet initial ou étant de composition différente de celle du nanocristal ou du nanofeuillet initial ou étant de composition différente entre elles.

Dans un mode de réalisation, le nanocristal colloïdal semi-conducteur anisotrope aplati peut comprendre le nanocristal ou nanofeuillet initial et au moins 2, 3, 4, 5 ou plus monocouches ou couches, dans lequel la première monocouche ou couche déposée recouvre tout ou partie du nanocristal ou nanofeuillet initial et la au moins deuxième monocouche ou couche déposée recouvre tout ou partie de la monocouche précédemment déposée.

Dans un mode de réalisation, le nanocristal colloïdal semi-conducteur anisotrope aplati présente une structure coeur/coque, i.e. un nanocristal ou un nanofeuillet initial d'une composition donnée recouvert sur toute sa surface d'au moins une monocouche ou couche de composition différente de celle du nanocristal ou du nanofeuillet initial.

Ainsi, le matériau obtenu est composé d'un empilement de films dont au moins un est de composition chimique identique ou différente du nanocristal ou du nanofeuillet initial, la surface de chaque film couvrant totalement la surface du film sur lequel il est déposé.

Dans un mode de réalisation, le nanocristal colloïdal semi-conducteur anisotrope aplati présente une structure démouillée, i.e. un nanocristal ou un nanofeuillet initial d'une composition donnée recouvert en partie d'au moins une monocouche ou couche de même composition ou de composition différente de celle du nanocristal ou du nanofeuillet initial.

Ainsi, le matériau obtenu est composé d'un empilement de films dont au moins un est de composition chimique identique ou différente du nanocristal ou nanofeuillet initial, la surface de chaque film couvrant partiellement la surface du film sur lequel il est déposé.

Ainsi, dans un mode de réalisation, le nanocristal semi-conducteur anisotrope aplati comporte une hétérostructure composée des matériaux énoncés ci-dessus.

Dans un mode de réalisation, le nanocristal colloïdal semi-conducteur anisotrope aplati est dopé par un lanthanide ou un métal de transition.

Dans un mode de réalisation, le nanocristal colloïdal semi-conducteur anisotrope aplati est recouvert d'un semi-conducteur de composition chimique différente.

Dans un mode de réalisation, le nanocristal colloïdal semi-conducteur anisotrope aplati est recouvert par des molécules organiques.

Dans un mode de réalisation, les molécules organiques sont choisies parmi les thiols, les amines, les acides carboxyliques, les acides phosphoniques, les acides phosphiniques, les phosphines.

Dans un mode de réalisation, le nanocristal colloïdal semi-conducteur anisotrope aplati est un feuillet colloïdal semi-conducteur.

Dans un mode de réalisation, le nanocristal colloïdal semi-conducteur anisotrope aplati présente un spectre de fluorescence étroit, de largeur à mi-hauteur inférieure à 30nm, à 25nm, à 24nm, à 23 nm, à 22nm, à 21nm ou à 20nm.

Dans un mode de réalisation, le nanocristal colloïdal semi-conducteur anisotrope aplati fluoresce à une longueur d'onde comprise entre 350 et 1500 nm.

La présente invention concerne également un composant comprenant au moins un dispositif émettant de la lumière en réponse à l'activation de moyens d'excitation, selon un mode de réalisation de l'invention, et un support pour ledit au moins un dispositif, ce support étant transparent pour la lumière émise par le dispositif dans au moins une direction vers un observateur situé à l'extérieur du composant, la face du support par laquelle la lumière est émise vers l'observateur étant définie face émettrice.

Ainsi, au sens de la présente invention, on définit un composant comme étant l'association d'au moins un dispositif émettant de la lumière en réponse à l'activation de moyens d'excitation tel que décrit dans la présente invention et d'un support dans lequel est placé ledit au moins un dispositif.

Dans un mode de réalisation, le au moins un dispositif émettant de la lumière en réponse à l'activation de moyens d'excitation est en contact avec le support.

Dans un mode de réalisation, le au moins un dispositif émettant de la lumière en réponse à l'activation de moyens d'excitation est intégré dans le support.

Dans un mode de réalisation, le au moins un dispositif émettant de la lumière en réponse à l'activation de moyens d'excitation est en contact avec un premier support et recouvert par un deuxième support ; lesdits premier et deuxième supports étant de même nature ou de nature différente.

La présente invention concerne également un système d'émission de lumière comportant un composant tel que décrit dans la présente invention et au moins un dispositif d'excitation selon un mode de réalisation de l'invention dans lequel les moyens d'excitation du au moins un dispositif sont intégrés au support.

Dans un mode de réalisation, les moyens d'excitation du au moins un dispositif sont intégrés au support.

Dans un mode de réalisation, les moyens d'excitation du au moins un dispositif sont extérieurs au support.

Dans un mode de réalisation, le composant comprend au moins deux dispositifs partageant le même moyen d'excitation.

Dans un mode de réalisation, le support contient un liquide.

Dans un mode de réalisation, le liquide a des propriétés des cristaux liquides.

Dans un mode de réalisation, le support contient au moins un matériau organique.

Dans un mode de réalisation, le support contient au moins un matériau semi-conducteur organique.

Dans un mode de réalisation, le support contient un matériau polymère.

Dans un mode de réalisation, le support est rigide.

Dans un mode de réalisation, le support est souple. Dans un mode de réalisation, le polymère est un polyélectrolyte.

Dans un mode de réalisation, le polymère comprend des fonctions chimiques pouvant se substituer aux ligands de surface des nanocristaux.

Dans un mode de réalisation, le polymère est un poly-méthacrylate de méthyle, un polystyrène, un polycarbonate, un polyéthylène, un polyéthylène téréphtalate, un époxyde, un polyester, un polysiloxane.

Dans un mode de réalisation, le polymère comprend un polymère semi-conducteur.

Dans un mode de réalisation, le polymère semi-conducteur comprend du polythiophène, du P3HT, du MDMO PPV, du MEH-PPV, du PEDOT, du PEDOT:PSS, du PCBM, du PCNEPV, du polyfluorène, du PSS.

Dans un mode de réalisation, le support contient au moins un matériau inorganique.

Dans un mode de réalisation, le matériau inorganique est un semi-conducteur.

Dans un mode de réalisation, le semi-conducteur contient l'un au moins des composés suivants : CdS, CdSe, CdTe, ZnS, ZnSe, ZnTe, AlN, GaN, InN, AlP, GaP, InP, AlAs, GaAs, InAs, C, Si, Ge.

Dans un mode de réalisation, le semi-conducteur est dopé, il contient en quantités minoritaires un élément produisant un excès ou un déficit d'électrons par rapport au semi-conducteur seul.

Dans un mode de réalisation, le matériau inorganique est un verre tel que la silice.

Dans un mode de réalisation, le matériau inorganique comprend un oxyde choisi parmi TiO₂, ITO (oxyde d'indium dopé à l'étain), NiO, ZnO, SnO₂, SiO₂, ZrO₂, FTO (oxyde d'étain dopé au fluor).

Dans un mode de réalisation, le matériau inorganique est un métal.

Dans un mode de réalisation, le composant comprend au moins deux dispositifs, les au moins deux nanocristaux colloïdaux semi-conducteurs anisotropes aplatis des au moins deux dispositifs ayant des caractéristiques différentes.

Dans un mode de réalisation, les dites caractéristiques sont les dimensions.

Dans un mode de réalisation, les dites caractéristiques sont les compositions chimiques.

Dans un mode de réalisation, les dites caractéristiques sont les longueurs d'onde d'émission.

Selon l'invention, sensiblement tous les nanocristaux aplatis du composant ont les normales à leurs surfaces sensiblement parallèles à une direction donnée.

Dans un mode de réalisation, les normales à la surface des nanocristaux aplatis du composant sont sensiblement parallèles à la normale à la face émettrice.

Dans un mode de réalisation, les normales à la surface des nanocristaux aplatis du composant sont sensiblement perpendiculaires à la normale à la face émettrice.

Dans un mode de réalisation, le support du composant comporte des moyens pour orienter le au moins un nanocristal aplati selon une au moins direction privilégiée.

Dans un mode de réalisation, le composant est fabriqué par un procédé dans lequel les nanocristaux aplatis sont déposés sur une surface d'appui avec la normale à leur surface sensiblement parallèle à la normale à la surface d'appui.

Dans un mode de réalisation, le composant est fabriqué par un procédé dans lequel la surface d'appui comprend une texturation.

Dans un mode de réalisation, le composant est fabriqué par un procédé comprenant une phase d'évaporation lente d'une solution contenant les nanocristaux aplatis.

Dans un mode de réalisation, la phase d'évaporation lente est réalisée tout en appliquant un champ électrique.

Dans un mode de réalisation, le composant est fabriqué par un procédé comprenant une étape de dépôt des nanocristaux aplatis par enduction centrifuge d'une solution contenant les nanocristaux colloïdaux aplatis.

Dans un mode de réalisation, le composant est fabriqué par un procédé comprenant une étape de dépôt des nanocristaux aplatis par trempage-retrait du substrat dans une solution contenant les nanocristaux colloïdaux aplatis.

Dans un mode de réalisation, la solution contenant les nanocristaux aplatis contient aussi un composé organique tel qu'un polymère ou un monomère.

Dans un mode de réalisation, le composant est fabriqué par un procédé comprenant une étape d'adsorption électrostatique couche par couche de nanocristaux aplatis présentant une charge de surface.

Dans un mode de réalisation, le composant est fabriqué par un procédé comprenant le transfert d'un film de nanocristaux aplatis orientés préalablement formé.

Dans un mode de réalisation, le film de nanocristaux est obtenu par évaporation lente sur une surface liquide d'une solution contenant les nanocristaux.

La présente invention a également pour objet un procédé de fabrication du composant selon un mode de réalisation de l'invention dans lequel les nanocristaux aplatis sont déposés sur une surface d'appui avec la normale à leur surface sensiblement parallèle à la normale à la surface d'appui.

Au sens de la présente invention sensiblement parallèle ou sensiblement perpendiculaire signifie que l'angle formé par les normales aux deux surfaces est de + 40° à - 40°, ou de + 30° à -30°, ou de + 20° à - 20°, ou de + 10° à - 10°, ou de +5° à - 5°.

La présente invention a également pour objet un appareil comprenant au moins un composant et/ou un système dans lequel des moyens sont prévus pour activer chaque composant et/ou système par des moyens d'excitation, indépendamment les uns des autres.

Dans un mode de réalisation, les moyens d'activation de l'appareil sont de type électrique et comprennent au moins deux réseau d'électrodes dans un arrangement matriciel.

Dans un mode de réalisation, des moyens d'activation sont prévus dans l'appareil pour appliquer aux électrodes des signaux électriques multiplexés dans le temps.

Dans un mode de réalisation, chacun des composants et/ou systèmes de l'appareil est associé à un composant électronique de type transistor placé aux points de la matrice de l'arrangement matriciel.

D'autres caractéristiques et avantages du dispositif selon l'invention apparaitront à la lecture de la description détaillée et des exemples de réalisation donnés ci-après à titre purement illustratif.

### BRÈVE DESCRIPTION DES FIGURES

La **figure 1** montre un schéma d'un mode de réalisation du dispositif tel que décrit dans l'invention.
La **figure 2** montre les spectres d'absorbance et de fluorescence de trois populations de feuillets de CdSe émettant à 460, 512 et 550nm.
La **figure 3** montre le diagramme de rayonnement d'un nanocristal colloïdal anisotrope aplati.
La **figure 4** montre la structure schématique vue en coupe d'une diode électroluminescente contenant des nanocristaux colloïdaux anisotropes aplatis, telle que décrite dans un mode de réalisation de l'invention.
Les **figures 5a et 5b** montrent un exemple de structure de bande des semi-conducteurs composant une hétéro-structure coeur/coque de type I et de type II.
La **figure 6** montre la structure schématique vue en coupe d'un exemple de composant tel que décrit dans un mode de réalisation de l'invention.
Les **figures 7a, 7b et 7c** présentent des structures schématiques vues en coupe de supports contenant des nanocristaux aplatis tel que décrit dans un mode de réalisation de l'invention.
Les **figures 8a et 8b** sont des vues schématiques respectivement de dessus et en coupe d'un mode de réalisation d'un composant dans lequel la normale aux nanocristaux est sensiblement parallèle à la normale à la face émettrice.
Les **figures 9a et 9b** sont des vues schématiques respectivement de dessus et en coupe d'un mode de réalisation d'un composant dans lequel la normale aux nanocristaux est sensiblement perpendiculaire à la normale à la face émettrice.
La **figure 10** est un schéma de principe vu en coupe d'un exemple de moyen d'orientation des feuillets par rapport à la face émettrice.
La **figure 11** montre un mode de réalisation d'un appareil, tel qu'un afficheur composé de plusieurs composants.

### DESCRIPTION DÉTAILLÉE

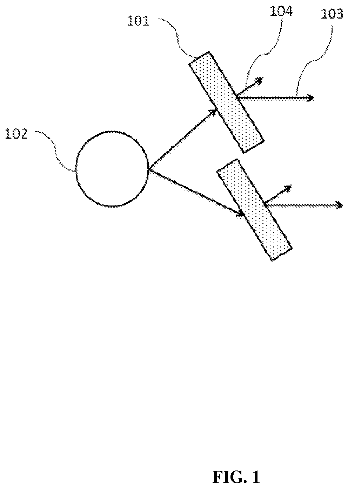

Un premier mode de réalisation d'un dispositif pour émettre de la lumière en réponse à l'activation de moyens d'excitation selon l'invention est représenté sur la figure 1. Dans la suite, on désignera par nanocristal aplati un nanocristal semi-conducteur colloïdal anisotrope dont la plus petite dimension, l'épaisseur, est plus petite que les deux autres d'un facteur 1.5 au moins. On désignera par feuillet un nanocristal aplati présentant au moins une dimension, l'épaisseur, de taille nanométrique et de dimensions latérales grandes devant l'épaisseur, typiquement plus de 5 fois l'épaisseur. On désignera par normale au nanocristal aplati la normale à la plus grande surface plane du nanocristal aplati.

Ce dispositif comprend au moins un nanocristal aplati 101, ainsi qu'un moyen d'excitation 102 de celui-ci. La lumière émise par le dispositif a une intensité et une polarisation qui varient en fonction de l'angle constitué par la direction d'émission de la lumière 103 et la normale à la plus grande surface du nanocristal aplati 104.

Les nanocristaux aplatis sont des fluorophores dont la longueur d'onde d'émission peut être choisie avec précision dans l'ensemble du spectre visible simplement en modifiant la composition et la structure des dits nanocristaux aplatis.

Dispersés dans une matrice transparente, les nanocristaux aplatis sont capables d'absorber tout rayonnement lumineux de longueur d'onde inférieure à leur longueur d'onde de fluorescence et de réémettre un rayonnement à la longueur d'onde de fluorescence. Ce sont donc des convertisseurs de longueur d'onde. Tous les nanocristaux aplatis, quelque soient leur composition et leur longueur d'onde de fluorescence, présentent une section efficace d'absorption élevée dans l'ultraviolet et le bleu. Il est ainsi possible d'exciter avec un même rayonnement ultraviolet ou bleu différents types de nanocristaux aplatis fluoresçant dans le bleu, le vert et le rouge par exemple.

La fluorescence d'un nanocristal de semi-conducteur provient de la recombinaison d'un exciton au sein de ce nanocristal. Compte tenu de la taille nanométrique du nanocristal, un effet de confinement quantique s'exerce sur l'exciton et décale vers le bleu la longueur d'onde de fluorescence par rapport à l'exciton en l'absence de confinement. Plus le nanocristal est petit, plus l'effet de confinement est fort et décale la fluorescence vers le bleu.

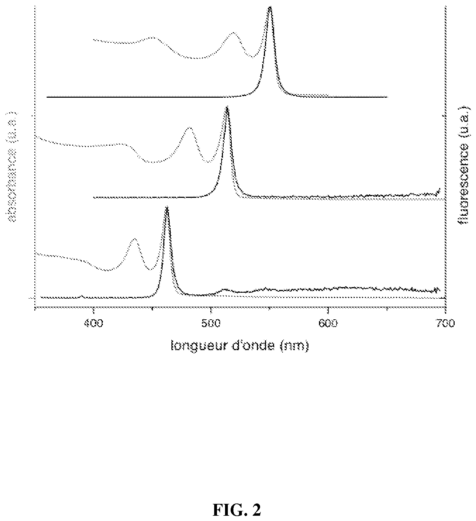

Dans le cas particulier des feuillets, l'épaisseur étant beaucoup plus faible que les dimensions latérales du nanocristal, l'effet de confinement quantique se fait sentir dans l'épaisseur uniquement. De plus, dans les feuillets, l'épaisseur peut être parfaitement définie, à la monocouche atomique près. L'association d'un confinement quantique dans une dimension seulement et d'un contrôle parfait de l'épaisseur permet d'atteindre des finesses spectrales de fluorescence jamais rapportées pour les nanocristaux semi-conducteurs isotropes. Ainsi, tel que décrit dans le brevet WO2010/029508 un ensemble de feuillets colloïdaux de semi-conducteurs peut présenter un spectre de fluorescence très étroit, de largeur à mi-hauteur du pic de fluorescence inférieure à 12 nm. Des exemples de spectres d'absorbance et de fluorescence de solutions de feuillets colloïdaux de semi-conducteurs sont représentés figure 2.

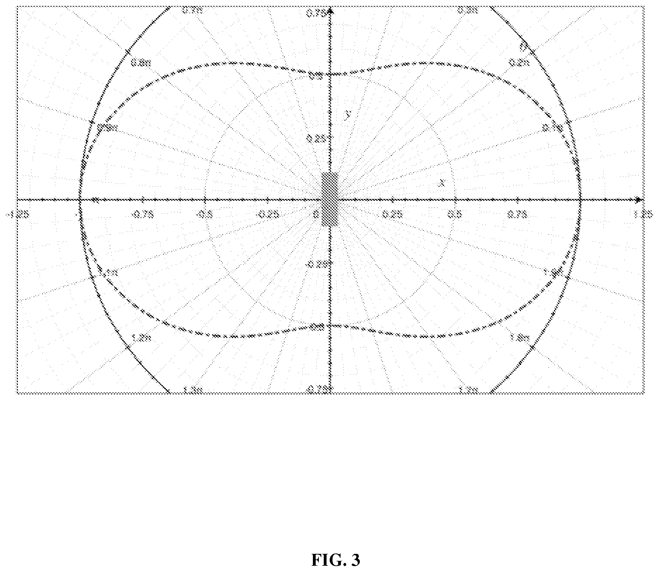

Les inventeurs ont constaté que les nanocristaux aplatis possèdent un diagramme de rayonnement particulier, représenté sur la figure 3. On observe un maximum selon une direction privilégiée, à savoir la normale à la surface du nanocristal aplati.

Les inventeurs ont également constaté que, suivant cette direction d'émission privilégiée, la lumière émise par le nanocristal aplati ne présente pas de polarisation particulière mais qu'à l'inverse, la lumière émise dans le plan du nanocristal aplati présente une polarisation rectiligne suivant celui-ci.

Les dispositifs, composants et appareils tels qu'ils seront décrits dans la suite exploitent ces deux propriétés.

Les moyens d'excitation du dispositif selon l'invention peuvent être de plusieurs natures.

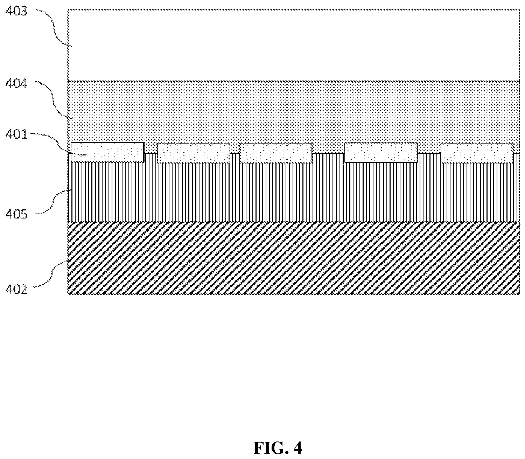

Ils peuvent comprendre des moyens d'injection de charges électriques, électrons et/ou trous, au sein du nanocristal aplati ainsi que schématisé sur la figure 4. Les électrons et/ou les trous sont injectés au sein du nanocristal aplati 401 par le biais d'électrodes 402 et 403, dont l'une au moins 403 est transparente dans le domaine spectral de la lumière émise par le nanocristal et de supports 404 et 405, ici des couches semi-conductrices respectivement de type n et de type p, déposées de part et d'autre d'une couche des nanocristaux 401.

Ce moyen d'excitation correspond en particulier aux diodes électroluminescentes. Il peut aussi correspondre aux appareils AC-TFEL (Alternating Current Thin Film ElectroLuminescence) dans lesquels les charges sont générées au sein d'une alternance de films isolants et émissifs par l'application d'une haute tension alternative. Le champ électrique alternatif induit par la tension appliquée génère des charges, en particulier aux interfaces isolant/ composé luminescent.

Les moyens d'excitation du dispositif peuvent comprendre des moyens d'application au nanocristal aplati d'un champ électromagnétique, ou d'ondes électromagnétiques telle que des ondes lumineuses choisies telles qu'une partie au moins des dites ondes est absorbée par le nanocristal aplati. Ce moyen d'excitation correspond en particulier aux convertisseurs de longueur d'onde qui contiennent des nanocristaux fluorescents : ceux-ci absorbent tout ou partie de la lumière d'excitation et émettent de la lumière à une autre longueur d'onde, généralement plus élevée que la longueur d'onde d'excitation.

Les moyens d'excitation du dispositif peuvent comprendre au moins un dipôle électrique ou magnétique couplé par interactions électromagnétiques au nanocristal aplati. Ce moyen d'excitation correspond en particulier aux excitations de type FRET (Förster Resonance Energy Transfer). Dans ce cas, un fluorophore donneur, initialement dans un état électronique excité, peut transférer son énergie à un fluorophore accepteur à travers un couplage dipolaire non-radiatif. Le fluorophore donneur peut être composé de fluorophores organiques, de nanocristaux semi-conducteurs fluorescents ou même de puits quantiques dans un état excité.

Le nanocristal aplati peut être composé de semi-conducteurs II-VI, III-V, IV-VI, II-V ou I-III-VI. En particulier, il peut contenir l'un au moins des composés suivants : CdTe, CdSe, CdS, ZnTe, ZnSe, ZnS, InP, InAs, InN, GaP, GaAs, GaN, PbS, PbSe, PbTe, CuInS₂, CuInSe₂, AgInS₂, AgInSe₂, Cd₃P₂.

Le nanocristal aplati peut être dopé par un lanthanide ou un métal de transition.

Dans un mode de réalisation de l'invention, le nanocristal aplati est recouvert d'un semi-conducteur de composition chimique différente. Ce type de structure est généralement appelé « coeur-coque » ou « coeur-coquille » (traduction de « core-shell » en anglais).

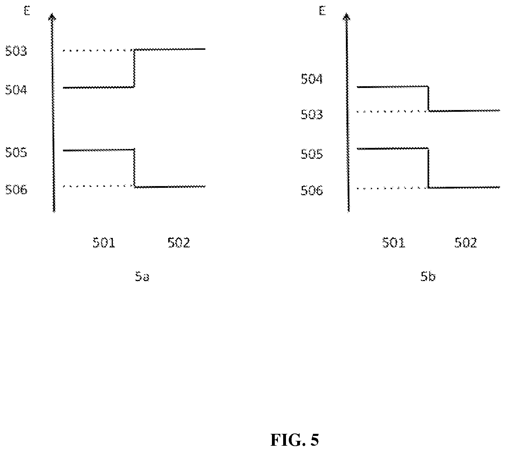

La figure 5a montre un exemple de structure de bande des semi-conducteurs composant une hétéro-structure coeur 501/coque 502 de type I. Quand le niveau d'énergie de la bande de conduction du semi-conducteur composant la coque 503 est plus élevé que le niveau d'énergie de la bande de conduction du semi-conducteur composant le coeur 504 et que le niveau d'énergie de la bande de valence du semi-conducteur composant la coque 505 est plus bas que le niveau d'énergie de la bande de valence du semi-conducteur composant le coeur 506, la bande interdite du semi-conducteur composant la coque est alors de largeur plus grande que celle du semi-conducteur composant le coeur, ce qui mène à la formation d'une hétéro-structure dite de type I, qui confine l'électron et le trou composant l'exciton dans le coeur de l'hétéro-structure.

La figure 5b montre un exemple de structure de bande des semi-conducteurs composant une hétéro-structure coeur 501 /coque 502 de type II. Quand le niveau d'énergie de la bande de conduction du semi-conducteur composant la coque 503 est plus bas que le niveau d'énergie de la bande de conduction du semi-conducteur composant le coeur 504 et que le niveau d'énergie de la bande de valence du semi-conducteur composant la coque 505 est plus bas que le niveau d'énergie de la bande de valence du semi-conducteur composant le coeur 506, l'hétéro-structure est dite de type II. Il y a séparation spatiale de l'électron et du trou, ceux-ci se localisant majoritairement dans le coeur ou la coque.

L'épaisseur de la coque peut varier d'une monocouche atomique à plusieurs dizaines de nanomètres. De plus, celle-ci peut être d'épaisseur homogène sur tout le nanocristal, ou à l'inverse d'épaisseur hétérogène, étant plus épaisse sur les grandes faces du nanocristal anisotrope aplati que sur les petites faces, ou inversement.

Le nanocristal aplati peut être recouvert par des molécules organiques. Celles-ci peuvent jouer le rôle de ligands de surface, c'est à dire qu'une fonction présente sur la molécule organique peut s'adsorber sur la surface du nanocristal. L'adsorption de ces ligands modifie les propriétés de fluorescence du nanocristal colloïdal semi-conducteur anisotrope aplati ; leur adsorption assure également la stabilité colloïdale des nanocristaux. Les molécules organiques sont choisies parmi les thiols, les amines, les acides carboxyliques, les phosphines.

Dans un mode de réalisation de l'invention, le nanocristal aplati contient un feuillet colloïdal semi-conducteur. On désigne par feuillet un nanocristal aplati présentant au moins une dimension, l'épaisseur, de taille nanométrique et des dimensions latérales grandes devant l'épaisseur, typiquement plus de 5 fois l'épaisseur. Le nanocristal aplati peut être lui-même un feuillet. Le nanocristal aplati peut alternativement contenir un feuillet au sein d'une structure coeur/coque par exemple.

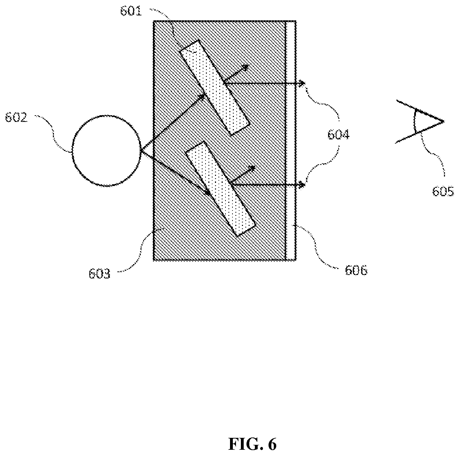

Dans un second mode de réalisation de l'invention, un composant est réalisé tel que représenté sur la figure 6, comprenant au moins un dispositif, comprenant lui-même au moins un nanocristal aplati 601, ainsi qu'un moyen d'excitation 602 de celui-ci. Ce au moins un dispositif est placé dans un support 603, ce support étant transparent pour la lumière émise par le dispositif dans au moins une direction 604 vers un observateur 605 situé à l'extérieur du composant, la face du support par laquelle la lumière est émise vers l'observateur étant définie face émettrice 606.

Les moyens d'excitation du dispositif peuvent être intégrés au support ou alternativement, les moyens d'excitation du au moins un dispositif peuvent être extérieurs au support.

Le composant peut contenir un ou plusieurs dispositifs et donc un ou plusieurs nanocristaux. De plus, dans un composant qui contient au moins deux dispositifs, les moyens d'excitation des dits dispositifs peuvent être partagés ou non.

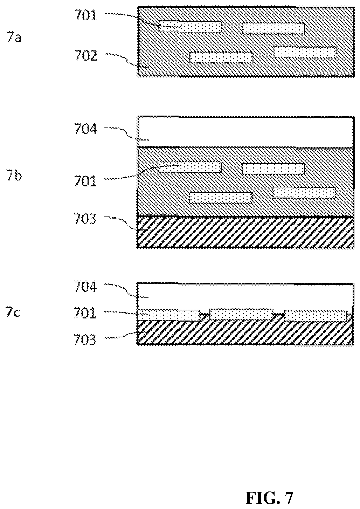

Le composant comprend un support dans lequel est placé le au moins un dispositif, ce support pouvant être constitué de diverses manières. Il peut par exemple être constitué d'un matériau organique, un polymère par exemple ou inorganique ; il peut être constitué, ainsi que schématisé sur la figure 7a d'un seul matériau 702 au sein duquel les nanocristaux 701 sont dispersés.

Il peut également être constitué, de plusieurs matériaux différents formant plusieurs couches.

Sur la figure 7b, les nanocristaux sont situés au sein d'une des couches et, sur la figure 7c, ils sont situés à l'interface entre deux couches différentes.

Le support est transparent dans au moins une direction pour la lumière émise par les nanocristaux, ce qui implique qu'une partie des couches 703 peut être opaque ou réfléchissante pour la lumière émise par les nanocristaux, tandis qu'une autre partie 704 doit être transparente pour celle-ci. Suivant les moyens d'excitation mis en oeuvre, le support peut également être transparent vis à vis d'une lumière d'excitation des nanocristaux. Enfin, suivant d'autres moyens d'excitation mis en oeuvre, le support peut comprendre des électrodes ainsi que des couches semi-conductrices organiques ou inorganiques.

Le support peut être constitué de diverses manières : il peut contenir un liquide, et en particulier un liquide ayant des propriétés des cristaux liquides.

Il peut également contenir au moins un matériau organique tel qu'un des matériaux bien connus pour la réalisation des diodes électroluminescentes à petites molécules comme Alq₃.

Le support peut contenir au moins un matériau polymère :
∘ Le polymère peut comprendre des fonctions chimiques pouvant se substituer aux ligands de surface des nanocristaux.
∘ Le polymère peut être un polyélectrolyte.
∘ Le polymère peut être un poly-méthacrylate de méthyle, un polystyrène, un polycarbonate, un polyéthylène, un polyéthylène téréphtalate, un époxyde, un polyester, un polysiloxane.
∘ Le polymère peut être un polymère semi-conducteur tel que du polythiophène, du P3HT, du MDMO PPV, du MEH-PPV, du PEDOT, du PEDOT:PSS, du PCBM, du PCNEPV, du polyfluorène, du PSS.

Le support peut contenir au moins un matériau inorganique :
∘ Le matériau inorganique peut être un semi-conducteur tel que un semi-conducteur II-VI : CdS, CdSe, CdTe, ZnS, ZnSe, ZnTe, III-V : AlN, GaN, InN, AlP, GaP, InP, AlAs, GaAs, InAs et les alliages de ceux-ci, un semi-conducteur intrinsèque tel que le carbone, le silicium ou le germanium.
∘ Le semi-conducteur peut être dopé.
∘ Le matériau inorganique peut être un verre tel que la silice.
∘ Le matériau inorganique peut être un oxyde : TiO₂, ITO (oxyde d'indium dopé à l'étain), NiO, ZnO, SnO₂, SiO₂, ZrO₂.
∘ Le matériau inorganique peut être un métal : or, argent, molybdène, aluminium...

Dans un mode de réalisation de l'invention, un composant peut comprendre au moins deux dispositifs, les au moins deux nanocristaux colloïdaux semi-conducteurs anisotropes aplatis des au moins deux dispositifs ayant des caractéristiques différentes. Les dites caractéristiques peuvent-être les dimensions ou les compositions chimiques. Cela permet de définir un composant présentant deux populations distinctes de nanocristaux qui émettent à deux longueurs d'ondes différentes.

Le diagramme d'émission particulier des nanocristaux colloïdaux semi-conducteurs aplatis peut être mis à profit si les nanocristaux du composant sont orientés. Il est possible de définir leur orientation soit par rapport aux autres nanocristaux présents dans le composant, soit par rapport à la face émettrice du composant. Pour cela, il est nécessaire d'introduire une normale au nanocristal colloïdal semi-conducteur anisotrope aplati, qui permettra de définir parfaitement l'orientation des nanocristaux. La normale au nanocristal est définie comme étant la normale à la plus grande surface du nanocristal aplati.

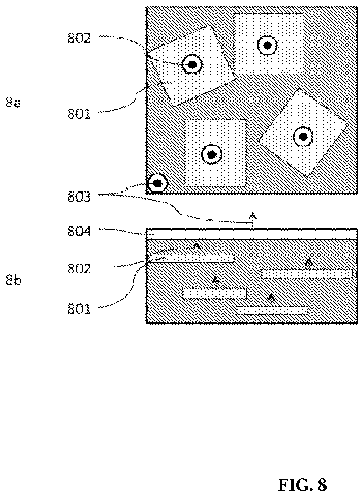

Si l'on oriente les nanocristaux par rapport à la face émettrice, on peut définir un composant dans lequel la normale à au moins un nanocristal est sensiblement parallèle à la normale à la face émettrice, ainsi que représenté figure 8a en vue du dessus et vue en coupe figure 8b. Si les nanocristaux aplatis 801 sont tous orientés au sein du composant de manière à ce que les normales aux nanocristaux aplatis 802 soient toutes alignées et parallèles à la normale 803 à la surface d'émission 804, on aura un émetteur émettant de manière privilégiée dans la direction du faisceau incident mais le rayonnement réémis sera non polarisé.

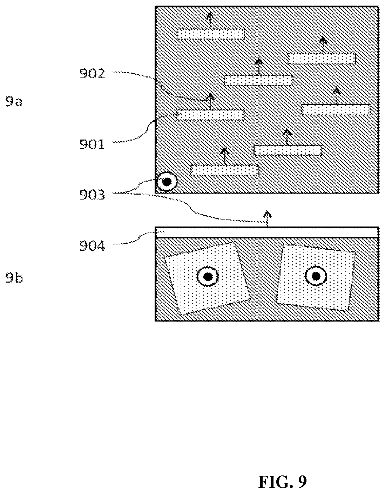

De même, si l'on oriente les nanocristaux par rapport à la face émettrice, on peut définir un composant dans lequel la normale à au moins un nanocristal est sensiblement perpendiculaire à la normale à la face émettrice, ainsi que représenté figure 9a en vue du dessus et vue en coupe figure 9b. Si les nanocristaux aplatis 901 sont tous orientés au sein du composant de manière à ce que les normales aux nanocristaux aplatis 902 soient toutes alignées et perpendiculaires à la normale 903 à la surface d'émission 904, on aura un émetteur émettant un rayonnement polarisé rectilignement.

Les situations d'orientation intermédiaires donneront lieu à des composants réémettant une lumière partiellement polarisée et/ou présentant une directivité moins prononcée.

Afin d'orienter les nanocristaux les uns par rapport aux autres, le composant doit contenir au moins deux nanocristaux, les normales aux surfaces des au moins deux nanocristaux étant sensiblement parallèles à une direction donnée. En particulier, sensiblement tous les nanocristaux du composant ont les normales à leurs surfaces sensiblement parallèles à une direction donnée. Ce cas de figure est en particulier représenté figures 8 et 9 où tous les nanocristaux du composant ont les normales à leurs surfaces sensiblement parallèles à une direction donnée, la direction étant respectivement soit la normale à la surface d'émission du composant, soit une perpendiculaire à la surface d'émission du composant.

Afin d'orienter les nanocristaux au sein du composant, le support peut comporter des moyens pour orienter ceux-ci selon une au moins direction privilégiée.

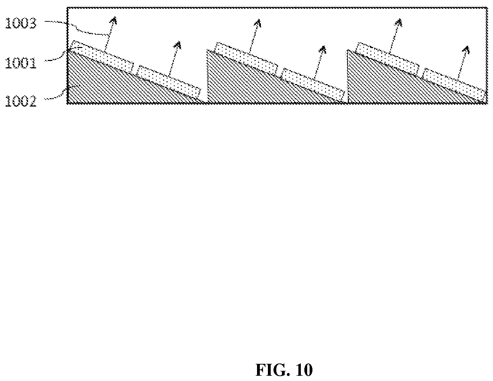

Du fait de la forme aplatie des nanocristaux, ceux-ci peuvent se déposer à plat sur les surfaces. Un premier moyen pour orienter les nanocristaux aplatis présenté figure 10 est de les déposer sur une surface 1002 d'orientation donnée située au sein du support, les nanocristaux 1001 se déposeront à plat sur celle-ci, la normale des nanocristaux 1003 sera donc parallèle à la normale à la surface. Les procédés de fabrication d'un composant comprenant des nanocristaux orientés pourront faire intervenir une surface d'appui au sein du composant sur laquelle les nanocristaux sont déposés.

Il est possible de mettre en oeuvre un procédé pour fabriquer un composant dans lequel les nanocristaux sont déposés sur une surface d'appui avec la normale à leur surface sensiblement parallèle à la normale à la surface d'appui.

Il est possible de mettre en oeuvre un procédé pour fabriquer un composant dans lequel la surface d'appui comprend une texturation. En effet, la surface d'appui peut ne pas être plane mais microstructurée par exemple. Un réseau blazé permettrait par exemple d'orienter majoritairement les nanocristaux selon un angle correspondant à l'angle du réseau blasé.

Afin de fabriquer un composant intégrant des nanocristaux orientés, il peut être avantageux de déposer les nanocristaux sur un substrat par une méthode qui permet aux nanocristaux aplatis de se déposer à plat sur le substrat. Le procédé de fabrication du composant peut comprendre :
o une étape de dépôt des nanocristaux par évaporation lente sur le substrat d'une solution les contenant,
o une étape de dépôt des nanocristaux par enduction centrifuge,
o une étape de dépôt des nanocristaux par trempage-retrait (« dip coating » en anglais »),
o une étape de dépôt des nanocristaux par adsorption électrostatique couche par couche.

Alternativement, un film de nanocristaux orientés peut être préparé préalablement puis transféré sur un substrat. Dans ce cas, et suivant le mode de préparation du film, celui-ci peut contenir des nanocristaux soit majoritairement horizontaux, soit majoritairement verticaux par rapport au film lui-même. Il est ainsi possible de mettre en oeuvre un procédé de fabrication du composant comprenant une étape de dépôt des nanocristaux par formation et transfert d'un film de Langmuir-Blodgett ou Langmuir-Schaefer.

Enfin, il peut être utile de déposer sur les nanocristaux aplatis une couche protectrice, un verre ou un polymère par exemple. Ce procédé étant répétable afin de former des composites multicouches « matrice/ nanocristaux aplatis ».

Une alternative afin d'orienter les nanocristaux est de préparer préalablement une solution contenant des nanocristaux aplatis et un polymère ou un précurseur du polymère puis polymériser et/ou évaporer le solvant en présence d'un champ électrique.

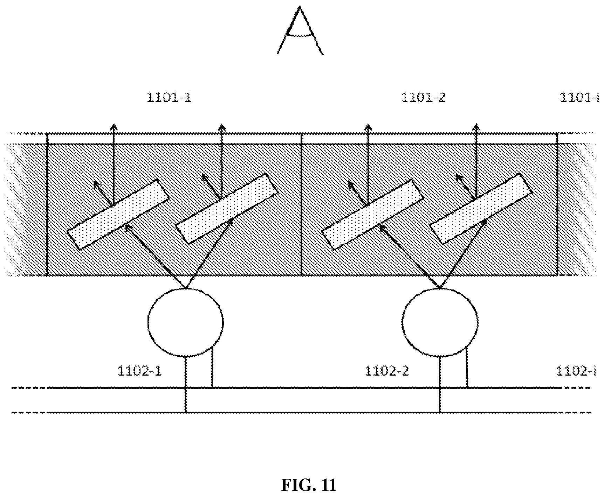

Une autre alternative afin d'orienter les nanocristaux est de préparer préalablement un composite polymère/nanocristaux-aplatis thermo-formable, les nanocristaux aplatis s'orienteront au sein de la matrice par les contraintes appliquées lors de la mise en forme du composite. Dans un troisième mode de réalisation, un appareil est réalisé tel que représenté figure 11, comprenant au moins un composant 1101-i tel que décrit ci-dessus, chaque composant pouvant être soumis à des moyens d'activation 1102-i indépendamment les uns des autres. Un tel appareil peut être un afficheur permettant de présenter à un observateur des images, des textes ou toute autre information visuelle. L'activation des moyens d'excitation des dispositifs composant l'appareil se fait généralement à l'aide d'un courant électrique. À cette fin, un appareil dans lequel les moyens d'activation sont de type électrique peut comprendre au moins deux réseaux d'électrodes dans un arrangement matriciel. De plus, des moyens peuvent être prévus pour appliquer aux électrodes des signaux électriques multiplexés dans le temps. L'appareil peut également être construit de manière à ce que chacun des composants soit associé à un composant électronique de type transistor placé aux points de la matrice de l'arrangement matriciel.

Cet adressage peut être fait de toute manière connue. Par exemple dans le cas d'un afficheur à diodes électroluminescentes, ce sont les diodes elles-mêmes qui sont adressées matriciellement. Dans le cas d'un affichage à éclairage commun à tous les pixels, tel qu'un dispositif d'affichage à cristaux liquides, ce sont les obturateurs qui sont adressés matriciellement.

Du fait de la faible largeur à mi-hauteur du pic de fluorescence des nanocristaux semi-conducteurs anisotropes aplatis en général et des feuillets en particulier, le dispositif peut présenter un spectre d'émission très étroit, de largeur à mi-hauteur du pic d'émission inférieur à 20nm.

### EXEMPLES

### Exemple 1 : Synthèse de nanocristaux aplatis à structure coeur/coque fluorescents

On décrit par exemple la synthèse de nanocristaux de semi-conducteurs aplatis fluorescents avec une structure coeur/coque.

### Synthèse de feuillets émettant à 510nm :

Les feuillets de CdSe par exemple peuvent être obtenus par toute méthode connue, tel que décrit par exemple dans les documents suivants : Ithurria, S.; Dubertret, B. Journal of the American Chemical Society 2008, 130, 16504-5 et Ithurria, S.; Bousquet, G.; Dubertret, B. Journal of the American Chemical Society 2011, 133, 3070-7. 174mg de Cd(myristate)₂ et 12mg de Sélénium en poudre sont introduits dans un ballon tricol contenant 16mL d' 1-octadecene (ODE, 90%). Le ballon est dégazé sous pression réduite et sous agitation à température ambiante durant 30 minutes. De l'Argon est introduit dans le ballon qui est alors chauffé. Quand la température atteint 200°C, 40mg de Cd(Acétate)₂(H₂O)₂ sont rapidement introduits dans le milieu réactionnel induisant la croissance des feuillets. Le milieu réactionnel est porté à 240°C, température à laquelle il est maintenu pendant environ 10 minutes afin d'assurer la croissance des feuillets. La solution est alors refroidie et lavée par précipitations et suspensions successives. La première précipitation est effectuée par ajout d'acide oléique (10mL environ), d'un non solvant : l'éthanol (70mL environ) et centrifugation (5000 tours par minute pendant 10minutes). Le surnageant est éliminé et le précipité suspendu dans de l'hexane (10mL environ). La solution de feuillets contient encore une grande quantité de Cd(myristate)₂ utilisé en excès. L'ajout de quelques millilitres d'octylamine (4mL) permet sa dissolution. La suspension de plaquettes est alors précipitée une deuxième fois par ajout d'éthanol (80mL) et centrifugation. Le procédé de suspension/ précipitation est répété encore 2 fois avec de l'octylamine puis une dernière fois simplement par suspension dans l'hexane et précipitation à l'éthanol. Le précipité final est suspendu dans 10mL d'hexane.

### Traitement visant à augmenter le rendement quantique de fluorescence :

Après les lavages successifs, les feuillets synthétisés ne présentent plus qu'une fluorescence très faible (moins de 1% de rendement quantique). Il est possible de leur faire retrouver un rendement quantique élevé (plusieurs dizaines de pourcents) par une modification des ligands de surface. A la solution de feuillets dans l'hexane est ajouté 200µL d'acide oléique ainsi que 20mg de Cd(Acétate)₂(H₂O)₂. La solution est alors chauffée à reflux pendant 2 heures.

### Croissance d'une coque sur les feuillets initiaux :

On décrit par exemple le dépôt d'un film de Cd_{0.7}Zn_{0.3}S sur les feuillets initiaux de CdSe.

Dans un pilulier sont introduits successivement 2mL de chloroforme, 400 µL de la solution de feuillets de CdSe, 20mg de thioacétamide (TAA) ainsi que 200 µL d'octylamine. La solution est placée sous agitation magnétique pendant une heure, ce qui entraine la dissolution complète du TAA puis un changement de couleur de la solution. 4mg de CdCl₂ ainsi que 3mg de Zn(NO₃)₂ sont alors introduits dans la solution de feuillets. Celle-ci change à nouveau graduellement de couleur tandis que le rendement quantique de fluorescence augmente fortement. Les précurseurs sont laissés à réagir sur les feuillets pendant 24 heures. Les feuillets sont alors agrégés par ajout de quelques gouttes d'éthanol et la solution est centrifugée 5 minutes à 5000 tours/min. Le surnageant contenant les précurseurs n'ayant pas réagi ainsi que des nanocristaux de CdZnS parasites est supprimé et le culot formé par les feuillets est dispersé dans 2mL de chloroforme auxquels sont ajoutés 20 mg de solution de Cd(tetradecylphosphonate)₂ (Cd(TDPA)₂) à 0.5M dans l'octadécène. Le rendement quantique de fluorescence chute alors fortement. Il raugmente par la suite sous rayonnement ultraviolet. Les feuillets sont alors purifiés par précipitation à l'éthanol, centrifugation et suspension dans l'hexane. Cette étape de purification peut être répétée plusieurs fois.

Alternativement, les feuillets CdSe/CdZnS peuvent être rendus dispersables en milieu polaire. Pour cela, l'étape de dépôt du Cd(TDPA)₂ est remplacée par une étape de dépôt de di-mercaptopropionate de cadmium (Cd(MPA)₂). Une fois les feuillets CdSe/CdZnS séparés par centrifugation, ils sont dispersés dans 2mL d'une solution aqueuse de Cd(MPA)₂ à 0.1M et pH 11. Après 10 minutes de sonication, le mélange est centrifugé, le surnageant supprimé et 2mL d'eau distillé sont ajoutés sur le précipité. Les feuillets sont alors parfaitement dispersables en solution aqueuse.

### Exemple 2 : Dépôt de nanocristaux de semiconducteurs aplatis sur un substrat plan, la normale aux feuillets parallèle à la normale à la surface du substrat plan

On décrit par exemple le dépôt de nanocristaux de semiconducteurs aplatis sur un substrat plan, de telle sorte à ce que la normale aux nanocristaux de semiconducteurs aplatis soit parallèle à la normale à la surface du substrat plan selon un mode de réalisation particulier de l'invention.

Les feuillets peuvent se déposer à plat sur la surface quand ils sont déposés par évaporation d'une solution diluée les contenant. Il est possible d'utiliser plusieurs techniques mettant à profit cette propriété.

Une première possibilité est de déposer les feuillets par évaporation directe d'une faible quantité de solvant contenant les feuillets. 1mg de feuillets sont dispersés dans 2mL d'un mélange 9:1 en volume d'hexane et d'octane. Une goutte du mélange est déposée sur une lame de verre. Du fait de la présence d'octane, la goutte s'étale et sèche de manière homogène, sans former d'anneau de concentration de feuillets élevé sur les bords (« coffee ring effect »). Une fois la goutte sèche, les feuillets déposés sont répartis de manière homogène sur toute la surface de la tâche et ils présentent majoritairement une orientation dans laquelle la normale des nanocristaux est parallèle à la normale à la surface.

Une seconde possibilité est de déposer les feuillets par enduction centrifuge. Dans un premier temps, une lame de verre de microscope (26mm par 26mm) est nettoyée à l'aide d'un plasma d'oxygène. Elle est ensuite fonctionnalisée au 3-mercaptopropyl-triethoxysilane par immersion pendant 10 minutes dans une solution à 1% en volume de 3-mercaptopropyl-triethoxysilane dans l'éthanol. La lame de verre est rincée 3 fois à l'éthanol puis séchée. Une solution de feuillets à 1mg/mL dans l'hexane est alors déposée sur la lame par enduction centrifuge à 1000tr/min durant 30 secondes.

Une troisième possibilité est de déposer les feuillets par trempage (« dip coating » en anglais). Une lame de verre préalablement nettoyée à l'isopropanol est immergée dans une solution de feuillets à 1mg/mL dans l'hexane. La lame de verre, orientée de manière à ce que la normale à sa surface soit dans le plan de l'interface air/solution, est lentement extraite de la solution à une vitesse constante de 1cm par minute, de manière à former un film homogène de feuillets sur la surface de verre.

Une quatrième possibilité est de déposer les feuillets par déposition d'un film de Langmuir-Blodgett ou de Langmuir-Schaefer de nanocristaux sur le substrat. Pour cela, un film de Langmuir de nanocristaux est réalisé en laissant s'évaporer lentement une solution de nanocristaux dans l'hexane sur une surface de diéthylène glycol (DEG) contenue dans une cuve en téflon. Le film obtenu peut ensuite être condensé par un barreau en téflon délimitant la surface de la cuve en deux parties. Une fois que le film a atteint la densité voulue, il est prélevé, soit en y appliquant directement la surface plane à recouvrir (dépôt de Langmuir-Schaefer), soit en extrayant lentement du DEG la surface à recouvrir tout en maintenant la densité voulue pour le film en diminuant sa surface en utilisant le barreau en teflon.

### Exemple 3 : Dépôt de feuillets sur un substrat microstructuré

Le substrat microstructuré est un réseau blazé. Ni l'évaporation directe ni l"enduction centrifuge ne peuvent s'appliquer ici. Le dépôt par trempage permet par contre l'obtention d'un film homogène de feuillets sur les surfaces du réseau blazé. Le protocole décrit dans l'exemple précédent est ici appliqué, il suffit seulement de s'assurer que le réseau est extrait de la solution avec les lignes qui le composent perpendiculaires à la surface du liquide.

### Exemple 4 : Fabrication d'une diode électroluminescente utilisant des polymères semiconducteurs

On décrit par exemple la fabrication d'une diode électroluminescente utilisant des polymères semiconducteurs selon un mode particulier de réalisation de l'invention.

La diode électroluminescente est généralement constituée d'une première électrode, d'une couche de polymère conducteur de trous, d'une couche de nanocristaux semiconducteurs, d'une couche de polymère conducteur d'électrons et d'une seconde électrode telle que schématisée figure X. Les couches conductrices d'électrons ou de trous sont optionnelles si le niveau de fermi de l'électrode permet l'injection directe des charges. Il est possible également d'insérer une couche bloquant les électrons ou une couche bloquant les trous.

Le substrat de verre recouvert d'une électrode transparente d'ITO (disponible commercialement) est tout d'abord lavé à l'isopropanol et au mélange piranha. Sur le substrat propre est ensuite déposé par enduction centrifuge (« spin coating » en anglais) une couche de poly(3,4-ethylendioxythiophene):poly-(styrenesulfonate) (PEDOT:PSS, couche conductrice de trous) de 30 nm d'épaisseur environ. L'ensemble est alors recuit à 250°C pendant 20 minutes. La couche émissive constituée de feuillets en CdSe/CdZnS est alors réalisée par enduction centrifuge à 2500rpm d'une solution à 10mg/mL de nanocristaux dans l'octane. Enfin, la contre électrode est réalisée par évaporation thermique de 2nm de LiF (fluorure de lithium) puis 100nm d'aluminium.

### Exemple 5 : Fabrication d'une diode électroluminescente utilisant des oxydes semiconducteurs

On décrit par exemple la fabrication d'une diode électroluminescente utilisant des oxydes semiconducteurs selon un mode de réalisation de l'invention.

La diode électroluminescente est constituée d'une première électrode transparente en ITO (indium thin oxide), d'une couche d'oxyde de nickel, d'une couche de nanocristaux colloïdaux fluorescents, d'une couche d'oxyde de zinc et d'une électrode d'argent, telle que schématisée figure 4.

Sur un substrat de verre propre, une anode en ITO de 60nm d'épaisseur est déposée par pulvérisation cathodique magnetron à travers un masque sous environnement inerte d'argon à une pression de 5 mtorr et une vitesse de 0.06 Å.s⁻¹. Le substrat est chauffé à 250°C durant le dépôt pour augmenter la conductivité de l'ITO. Une couche de 20nm d'épaisseur de NiO dopé p (couche conductrice de trous) est ensuite déposée également par pulvérisation cathodique magnetron à une vitesse de 0.2 Å.s⁻¹ sous une atmosphère à 2 :100.d'oxygène dans de l'argon et une pression de 6mtorr.

Une couche dense de feuillets CdSe/CdZnS est déposée sur le NiO par enduction centrifuge sous atmosphère d'azote d'une solution de feuillets dispersés dans l'hexane. La concentration de la solution de feuillets est ajustée pour obtenir un dépôt d'une dizaine de nanomètres d'épaisseur.

La couche conductrice d'électrons est ensuite déposée sur les feuillets par dépôt cathodique simultané de ZnO à 15W et de SnO₂ à 9W sous atmosphère d'argon d'une pression de 5 mtorr. La vitesse de dépôt est de 0.2Å.s⁻¹.

Enfin, l'électrode d'argent de 40nm d'épaisseur est déposée par évaporation thermique à travers un masque sur la couche de ZnO:SnO₂ à une vitesse de 1.5Å.s⁻¹.

### Exemple 6 : Fabrication d'un film polymère contenant des nanocristaux aplatis de semiconducteurs - convertisseur de longueur d'onde

On décrit par exemple le dépôt d'un film polymère contenant des nanocristaux aplatis de semiconducteurs - convertisseur de longueur d'onde selon un mode de réalisation de l'invention.

Le polymère utilisé est un polymère statistique contenant 95% de méthacrylate de méthyle et 5% d'acide acrylique. C'est un polyméthacrylate de méthyle - polyacrylique acide (PMMA-PAA) disponible commercialement.

Dans un ballon tricol sont introduits la solution de feuillets dans le toluène, 10mg de Cd(Acétate)₂(H₂O)₂ ainsi que 2 grammes de polymère (PMMA-PAA) préalablement dissous dans 10mL d'anisole. L'ensemble est chauffé à 100°C pendant 2heures sous agitation magnétique. Après refroidissement jusqu'à température ambiante, le mélange présente un rendement quantique élevé. Le composite polymère/feuillets est précipité par ajout de 10mL d'hexane puis centrifugé. Le surnageant est supprimé et le précipité dissous dans quelques millilitres d'anisole. Le composite obtenu peut être mis en forme.

Dans un mode de réalisation, la mise en forme du composite est réalisée par enduction centrifuge (« spin-coating ») afin de former un film mince de composite polymère/feuillets. Dans un autre mode de réalisation, le composite est séché puis est mis en forme par thermoformage.

### Exemple 7 : Fabrication d'un film composite nanocristaux/polymère par assemblage électrostatique couche par couche

Dans un mode de réalisation de l'invention, un substrat rigide (lame de verre ou lame de PMMA par exemple) ou flexible (film de polyethylene basse densité par exemple) préalablement nettoyé est utilisé comme support. Un film de polymère polycationique, le poly(diallyldimethylammonium chloride) (PDDA, Mw = 5000 - 20000) est déposé sur le support par trempage de celui-ci dans une solution à 20g/L de PDDA et pH 9 (ajusté par ajout de TBAOH : hydroxide de tetrabutylammonium) durant 20 minutes. Après un rinçage à l'eau ultra-pure (>18MΩ cm) le support est immergé dans une solution aqueuse à 100mg/L de feuillets stabilisés à l'acide mercaptopropionique (chargés négativement) pendant 20 minutes également. Le film formé est rincé à l'eau ultra-pure.

Dans un mode de réalisation de l'invention, un film multicouche peut être obtenu en répétant les deux étapes d'adsorption du PDDA et des feuillets.

### Exemple 8 : Fabrication d'un film polymère contenant des feuillets ainsi que des nanocristaux fluorescents. Excitation par transfert d'énergie non radiatif

L'excitation par transfert d'énergie non-radiatif est réalisée par FRET (Förster Resonance Energy Transfer) entre un fluorophore accepteur, qui est un feuillet coeur/coque CdSe/CdZnS hydrosoluble préparé selon l'exemple 1 et des fluorophores donneurs : des nanocristaux semiconducteurs colloïdaux ZnSe/ZnS préparés par toute méthode connue.

Afin de mettre en oeuvre l'excitation par FRET des feuillets semiconducteurs, les nanocristaux ZnSe/ZnS doivent se situer au plus près des feuillets semiconducteurs. Dans un premier temps, on préparera une dispersion de feuillets sur lesquels sont adsorbés les nanocristaux de ZnSe/ZnS.

Pour cela, les nanocristaux ZnSe/ZnS sont tout d'abord échangés avec un ligand hydrosoluble cationique selon toute méthode connue, le ligand hydrosoluble cationique peut en particulier être un acide dihidrolipoïque fonctionnalisé avec une amine ou un ammonium quaternaire.

10 mg de feuillets CdSe/CdZnS hydrosolubles et présentant une charge de surface négative sont dispersés dans 10mL d'eau ultra pure. À cette solution est rajouté goutte par goutte 10mL d'une solution de 40mg de nanocristaux ZnSe/ZnS de charge de surface positive dispersés dans l'eau préalablement synthétisés. Feuillets et nanocristaux s'assemblent par interactions électrostatiques. Les complexes feuillets/nanocristaux sont purifiés par centrifugation et dispersés dans 10mL d'eau ultrapure. À cette solution est ajouté 10mL une solution aqueuse de PVA (alcool poly-vinylique) à 10mg/mL. La solution est placée dans un moule de taille approprié et l'eau est évaporée à l'étuve à 65°C jusqu'à séchage complet du film composite.

### Exemple 9 : Utilisation de nanocristaux de semiconducteurs aplatis lors de la fabrication d'un écran avec un rétro-éclairage

Dans un mode de réalisation de l'invention, les nanocristaux de semiconducteurs aplatis sont déposés sur un substrat transparent pouvant être souple comme le plastique ou rigide comme du verre. Le substrat est placé entre la source rétroéclairée émettant dans le bleu et la face extérieure et transparente de l'écran lors de sa fabrication.

### Exemple 10 : Utilisation de nanocristaux aplatis de semiconducteurs aplatis lors de la fabrication d'un écran émissif

Dans un mode de réalisation de l'invention, les nanocristaux de semiconducteurs aplatis sont déposés sur un substrat afin de former un assemblage dense pouvant être orienté. Les nanocristaux de semiconducteurs aplatis sont transférés à l'aide d'un tampon sur une matrice conçue pour pouvoir exciter les nanocristaux afin qu'ils émettent de la lumière.

### Bibliographie :

1. Amstutz et al. US patent application n° 4,634,229
2. Shi et al. US patent application n° 5,705,285
3. Suzuki et al. worldwide patent application n°WO2010/028728
4. Jeong et al. *Korean patent application n°* 1020100089606
5. Kazlas, P.; Linton, J. R. worldwide patent application n°WO2009/011922
6. Rho et al. *Korean patent application n°* 1020090036373
7. Sokolik, I.; Campos, R. A. *worldwide patent application n°*00/17903
8. Bawendi et al. US patent application n°6,501,091
9. Kim, et al. Nature Photonics 2011, 5, 176-182.

## Revendications

1. Un composant, pour émettre de la lumière en réponse à l'activation de moyens d'excitation, comprenant un support et une pluralité de nanocristaux colloïdaux semi-conducteurs anisotropes aplatis dont la plus petite dimension, à savoir l'épaisseur, est plus petite que les deux autres dimensions d'un facteur 1,5 au moins ; ladite lumière émise ayant une intensité et une polarisation qui varient en fonction de l'angle constitué par la direction d'émission de la lumière et la normale à la plus grande surface du nanocristal aplati,
**caractérisé en ce que**
sensiblement tous les nanocristaux aplatis ont les normales à leurs surfaces sensiblement parallèles à une direction donnée.

2. Un composant selon la revendication **1,** dans lequel les normales à la plus grande surface des nanocristaux colloïdaux semi-conducteurs anisotropes aplatis sont sensiblement parallèles ou sensiblement perpendiculaires au support.

3. Un composant selon la revendication **1** ou la revendication **2** dans lequel les nanocristaux colloïdaux semi-conducteurs anisotropes aplatis sont des nanofeuillets colloïdaux semi-conducteurs.

4. Un composant selon l'une quelconque des revendications précédentes dans lequel les nanocristaux colloïdaux semi-conducteurs anisotropes aplatis contiennent l'un au moins des composés du groupe IV, du groupe III-V, du groupe II-VI, du groupe III-VI, du groupe I-III-VI, du groupe II-V ou du groupe IV-VI.

5. Un composant selon l'une quelconque des revendications précédentes dans lequel les nanocristaux colloïdaux semi-conducteurs anisotropes aplatis contiennent l'un au moins des composés suivants : Si, Ge, CdS, CdSe, CdTe, ZnS, ZnSe, ZnTe, HgS, HgSe, HgTe, PbS, PbSe, PbTe, CuInS₂, CuInSe₂, AgInS₂, AgInSe₂, CuS, Cu₂S, Ag₂S, Ag₂Se, Ag₂Te, InN, InP, InAs, InSb, In₂S₃, Cd₃P₂, Zn₃P₂, Cd₃As₂, Zn₃As₂, ZnO, AlN, AlP, AlAs, AlSb, GaN, GaP, GaAs, GaSb, FeS₂, TiO₂, Bi₂S₃, Bi₂Se₃, Bi₂Te₃.

6. Un composant selon l'une quelconque des revendications précédentes dans lequel les nanocristaux colloïdaux semi-conducteurs anisotropes aplatis ont une hétéro-structure comprenant un nanocristal colloïdal semi-conducteur anisotrope aplati.

7. Un composant selon l'une quelconque des revendications précédentes dans lequel les nanocristaux colloïdaux semi-conducteurs anisotropes aplatis sont recouverts totalement d'un semi-conducteur de composition chimique différente.

8. Un composant selon l'une quelconque des revendications précédentes dans lequel les nanocristaux colloïdaux semi-conducteurs anisotropes aplatis présentent un spectre de fluorescence étroit, de largeur à mi-hauteur inférieure à 30nm, ou à 25nm, ou à 23nm, ou préférentiellement à 20nm.

9. Un composant selon l'une quelconque des revendications précédentes, dans lequel le support est transparent pour la lumière émise dans au moins une direction vers un observateur situé à l'extérieur du composant, la face du support par laquelle la lumière est émise vers l'observateur étant définie face émettrice.

10. Un composant selon l'une quelconque des revendications précédentes, dans lequel le support contient un liquide ayant les propriétés des cristaux liquides.

11. Un composant selon l'une quelconque des revendications précédentes, dans lequel le support est souple ou rigide.

12. Un composant selon l'une quelconque des revendications précédentes, dans lequel le support comprend un matériau inorganique ou un matériau organique, de préférence ledit matériau inorganique ou matériau organique est un matériau polymère.

13. Un composant selon l'une quelconque des revendications précédentes, dans lequel les nanocristaux colloïdaux semi-conducteurs anisotropes aplatis ont des caractéristiques, dimensions et/ou compositions chimiques et/ou longueurs d'onde d'émission, différentes.

14. Un système d'émission de lumière comportant un composant selon l'une quelconque des revendications **1** à **13** et au moins un moyen d'excitation comprenant des moyens d'application aux nanocristaux colloïdaux semiconducteurs anisotropes aplatis d'un champ électromagnétique, notamment une source lumineuse, dont une partie au moins de la lumière émise est absorbée par les nanocristaux colloïdaux semiconducteurs anisotropes aplatis, telle une diode à base de nitrure de gallium.

15. Un appareil comprenant au moins un composant et/ou un système selon l'une quelconque des revendications précédentes.

## Patentansprüche

1. Komponente zum Emittieren von Licht in Reaktion auf die Aktivierung von Erregungsmitteln, umfassend einen Träger und eine Vielzahl von abgeflachten anisotropen halbleitenden kolloidalen Nanokristallen, von denen die kleinste Abmessung, d. h. die Dicke, mindestens um einen Faktor 1,5 kleiner als die zwei anderen Abmessungen ist; wobei das emittierte Licht eine Intensität und eine Polarisierung aufweist, die je nach dem Winkel variieren, der durch die Richtung der Emission des Lichts und die Normale an der größten Oberfläche des abgeflachten Nanokristalls gebildet ist,
**dadurch gekennzeichnet, dass**
im Wesentlichen alle abgeflachten Nanokristalle die normalen an ihren Oberflächen im Wesentlichen parallel zu einer bestimmten Richtung aufweisen.

2. Komponente nach Anspruch 1, wobei die Normalen an der größten Oberfläche der abgeflachten anisotropen halbleitenden kolloidalen Nanokristalle im Wesentlichen parallel oder im Wesentlichen senkrecht zum Träger sind.

3. Komponente nach Anspruch **1** oder Anspruch **2,** wobei die abgeflachten anisotropen halbleitenden kolloidalen Nanokristalle halbleitende kolloidale Nanoblätter sind.

4. Komponente nach einem der vorhergehenden Ansprüche, wobei die abgeflachten anisotropen halbleitenden kolloidalen Nanokristalle mindestens eine der Verbindungen der Gruppe IV, der Gruppe III-V, der Gruppe II-VI, der Gruppe III-VI, der Gruppe I-III-VI, der Gruppe II-V oder der Gruppe IV-VI umfassen.

5. Komponente nach einem der vorhergehenden Ansprüche, wobei die abgeflachten anisotropen halbleitenden kolloidalen Nanokristalle mindestens eine der folgenden Verbindungen enthalten: Si, Ge, CdS, CdSe, CdTe, ZnS, ZnSe, ZnTe, HgS, HgSe, HgTe, PbS, PbSe, PbTe, CuInS₂, CuInSe₂, AgInS₂, AgInSe₂, CuS, Cu₂S, Ag₂S, Ag₂Se, Ag₂Te, InN, InP, InAs, InSb, In₂S₃, Cd₃P₂, Zn₃P₂, Cd₃As₂, Zn₃As₂, ZnO, AlN, AlP, AlAs, AlSb, GaN, GaP, GaAs, GaSb, FeS₂, TiO₂, Bi₂S₃, Bi₂Se₃, Bi₂Te₃.

6. Komponente nach einem der vorhergehenden Ansprüche, wobei die abgeflachten anisotropen halbleitenden kolloidalen Nanokristalle eine Heterostruktur aufweisen, umfassend ein abgeflachtes anisotropes halbleitendes kolloidales Nanokristall.

7. Komponente nach einem der vorhergehenden Ansprüche, wobei die abgeflachten anisotropen halbleitenden kolloidalen Nanokristalle vollständig von einem Halbleiter mit verschiedener chemischer Zusammensetzung bedeckt sind.

8. Komponente nach einem der vorhergehenden Ansprüche, wobei die abgeflachten anisotropen halbleitenden kolloidalen Nanokristalle ein enges Fluoreszenzspektrum der Breite bei mittlerer Höhe von weniger als 30 nm oder als 25 nm oder als 23 nm oder vorzugsweise als 20 nm aufweisen.

9. Komponente nach einem der vorhergehenden Ansprüche, wobei der Träger für das emittierte Licht in mindestens einer Richtung hin zu einem Betrachter, der sich außerhalb der Komponente befindet, transparent ist, wobei die Seite des Trägers, durch die das Licht hin zum Betrachter emittiert wird, als emittierende Seite definiert ist.

10. Komponente nach einem der vorhergehenden Ansprüche, wobei der Träger eine Flüssigkeit mit den Eigenschaften der Flüssigkristalle enthält.

11. Komponente nach einem der vorhergehenden Ansprüche, wobei der Träger flexibel oder starr ist.

12. Komponente nach einem der vorhergehenden Ansprüche, wobei der Träger ein anorganisches Material oder ein organisches Material umfasst, vorzugsweise das anorganische Material oder das organische Material ein polymeres Material ist.

13. Komponente nach einem der vorhergehenden Ansprüche, wobei die abgeflachten anisotropen halbleitenden kolloidalen Nanokristalle verschiedene Eigenschaften, Abmessungen und/oder chemische Zusammensetzungen und/oder Emissionswellenlängen aufweisen.

14. System zur Emission von Licht, umfassend eine Komponente nach einem der Ansprüche **1** bis **13** und mindestens ein Erregungsmittel, umfassend Mittel zur Anwendung auf die abgeflachten anisotropen halbleitenden kolloidalen Nanokristalle eines elektromagnetischen Felds, insbesondere einer Lichtquelle, wobei mindestens ein Teil des emittierten Lichts durch die abgeflachten anisotropen halbleitenden kolloidalen Nanokristalle wie z. B. einer Diode auf der Grundlage von Galliumnitrid absorbiert wird.

15. Gerät, umfassend mindestens eine Komponente und/oder ein System nach einem der vorhergehenden Ansprüche.

## Claims

1. A component to emit light in response to activation of excitation means, comprising a support, and a plurality of anisotropic flat colloidal semiconductor nanocrystals whose smallest dimension, namely the thickness, is smaller than the other two dimensions by a factor of at least 1.5, said emitted light having an intensity and a polarization which vary according to the angle formed by the light emitting direction and the normal to the largest surface of the flat nanocrystal, **characterised in that** substantially all of the flat nanocrystals have the normal to their surfaces substantially parallel to a given direction.

2. Component according to claim **1,** wherein the normals to the largest surface of the anisotropic flat colloidal semiconductor nanocrystals are substantially parallel or substantially perpendicular to the support.

3. Component according to claim **1** or claim **2,** wherein the anisotropic flat colloidal semiconductor nanocrystals are colloidal semiconductor nanosheets.

4. Component according to any one of the preceding claims, wherein the anisotropic flat colloidal semiconductor nanocrystals comprise at least one compound of group IV, group III-V, group II-VI, group III-VI, group I-III-VI, group II-V, or group IV-VI.

5. Component according to any one of the preceding claims, wherein the anisotropic flat colloidal semiconductor nanocrystals comprises at least one of the following compounds: Si, Ge, CdS, CdSe, CdTe, ZnS, ZnSe, ZnTe, HgS, HgSe, HgTe, PbS, PbSe, PbTe, CuInS₂, CuInSe₂, AgInS₂, AgInSe₂, CuS, Cu₂S, Ag₂S, Ag₂Se, Ag₂Te, InN, InP, InAs, InSb, In₂S₃, Cd₃P₂, Zn₃P₂, Cd₃As₂, Zn₃As₂, ZnO, AlN, AlP, AlAs, AlSb, GaN, GaP, GaAs, GaSb, FeS₂, TiO₂, Bi₂S₃, Bi₂Se₃, Bi₂Te₃.

6. Component according to any one of the preceding claims, wherein the anisotropic flat colloidal semiconductor nanocrystals have a heterostructure comprising an anisotropic flat colloidal semiconductor nanocrystal.

7. Component according to any one of the preceding claims, wherein the anisotropic flat colloidal semiconductor nanocrystals are totally covered with a semiconductor of different chemical composition.

8. Component according to any one of the preceding claims, wherein the anisotropic flat colloidal semiconductor nanocrystals exhibit a narrow fluorescence spectrum, with a full width at half maximum of less than 30nm, or 25nm, or 23nm, or preferentially 20nm.

9. Component according to any one of the preceding claims, wherein the support is transparent for the emitted light in at least one direction towards an observer located outside the component, the support face through which the light is emitted towards the observer being defined as an emitting face.

10. Component according to any one of the preceding claims, wherein the support comprises a liquid having liquid crystals properties.

11. Component according to any one of the preceding claims, wherein the support is flexible or rigid.

12. Component according to any one of the preceding claims, wherein the support comprises an inorganic material or an organic material, preferentially said inorganic material or organic material is a polymer material.

13. Component according to any one of the preceding claims, wherein the anisotropic flat colloidal semiconductor nanocrystals have different characteristics, dimensions and/or chemical compositions and/or emission wavelengths.

14. A light emitting system comprising a component according to any one of claims **1** to **13** and at least one excitation means comprising means for applying to the anisotropic flat colloidal semiconductor nanocrystals an electromagnetic field, in particular a light source, where at least part of the emitted light is absorbed by the anisotropic flat colloidal semiconductor nanocrystals, such as a gallium nitride diode.

15. An apparatus comprising at least one component and/or light emitting system according to any one of the preceding claims.
